# EUROPEAN PATENT APPLICATION

(11) **EP 4 646 081 A1**
(43) Date of publication of application: **05.11.2025**
(21) Application number: 23912766.5
(22) Date of filing: 21.12.2023
(51) Int. Cl.: H10K 59/123, H10K 59/35, H10K 59/80, H10K 59/124, H10K 59/38, H10K 59/122, H10K 50/17

(54) **ORGANIC LIGHT-EMITTING DISPLAY DEVICE**

(30) Priority: 30.12.2022 KR 20220190848
(71) Applicant: Yas Co., Ltd., Paju-si, Gyeonggi-do 10857 (KR); Ahn, Byungchul, Seoul 06574 (KR)
(72) Inventor: AHN, Byungchul, Seoul 06574 (KR)
(74) Representative: Epping - Hermann - Fischer
(86) International application number: PCT/KR2023/021214
(87) International publication number: WO 2024/144091

(57) **Abstract**

In an embodiment, a subpixel can include an auxiliary electrode, a light guide body with a three-dimensional structure on the auxiliary electrode, and an organic light-emitting element on the light guide body. The organic light-emitting element is disposed on a surface of the light guide body, so that a light-emitting area of the organic light-emitting element can be expanded. Since each of the auxiliary electrode and the organic light-emitting element has a reflective function, light emitted from the organic light-emitting element can be reflected by the auxiliary electrode and the organic light-emitting element and be reflected by the light guide repeatedly. Accordingly, light extraction efficiency can be dramatically increased and luminance can be improved.

## Description

### BACKGROUND OF THE DISCLOSURE

### Field

The embodiment relates to an organic light-emitting display device.

### Discussion of the Related Art

In the information age, the display industry has developed rapidly, and a display device is transitioning from a liquid crystal display to an organic light-emitting display (OLED). The market for the organic light-emitting display is expanding, focusing on a small display such as a portable product, but expansion into a medium-sized display market such as a laptop and a monitor is being delayed because there are many challenges to overcome, such as luminance and lifespan. Due to the performance of these products and limitations in price competitiveness, there is a significant technical barrier for an organic light-emitting display to replace a liquid crystal display.

By applying technology that enables in-line mass production with large-area substrates (e.g., 8th generation or higher substrates) without using fine metal mask (FMM), productivity improvement is expected to ensure price competitiveness in addition to a comprehensive solution to the above-mentioned cost-effectiveness issues. Currently, OLED TV is a bottom-emission display device using white organic light-emitting diodes (WOLED), and is the optimal structure for high productivity production in large-area equipment.

However, due to the limitation of the aperture ratio, which is the ratio of the area through which light passes through the pixel, the bottom-emission method makes it difficult to secure the aperture ratio in a high-resolution organic light-emitting display device at the level required for a medium-sized display. To this end, there are limitations that cannot be overcome by improving the performance of the TFT on the substrate and the driving circuit.

Therefore, in order to overcome the limitations of this technology, at the same time as applying the WOLED method, technology is needed to increase the amount of light emitted from the organic light-emitting element and to maximize the increased amount of light. If this technology is developed, it is possible to transform into a high-luminance and large-sized product such as digital signage, as well as to develop a display device using an organic light-emitting device into the high-resolution product area by improving the luminance and lifespan of products. Therefore, the development of such a groundbreaking organic light-emitting display device is urgently needed.

### SUMMARY OF THE DISCLOSURE

An object of the embodiment is to solve the foregoing and other problems.

The object of the embodiment is to provide an organic light-emitting display device and a manufacturing method thereof to improve the luminance and lifespan of the product by increasing the amount of light emitted by increasing a light-emitting area of the organic light-emitting element within the pixel.

The technical problems of the embodiments are not limited to those described in this item and include those that can be understood through the description of the invention.

In order to achieve the above-mentioned problem, according to one aspect of the embodiment, an organic light-emitting display device, comprising: a plurality of pixels, wherein each of the plurality of pixels comprises a plurality of subpixels, wherein each of the plurality of subpixels comprises: a driving circuit; a protective layer on the driving circuit; a color resin layer on the protective layer; a planarization layer on the color resin layer; an auxiliary electrode on the planarization layer; a light guide body having a three-dimensional structure on the auxiliary electrode; an organic light-emitting element on the light guide body; and an encapsulation layer on the organic light-emitting element, wherein the auxiliary electrode is configured to be connected to the driving circuit, wherein the driving circuit comprises a first opening portion, wherein the auxiliary electrode comprises a second opening portion and a reflection portion, and wherein light emitted from the organic light-emitting element is configured to be reflected in the reflection portion, be guided by the light guide body, and be emitted in the lower direction via the first opening portion, the color resin layer, and the second opening portion.

According to one aspect of an embodiment, an organic light-emitting display device, comprising: a plurality of pixels, wherein each of the plurality of pixels comprises a plurality of subpixels, wherein each of the plurality of subpixels comprises: a driving circuit; an auxiliary electrode on the driving circuit; a light guide body having a three-dimensional structure on the auxiliary electrode; an organic light-emitting element on the light guide body; an encapsulation layer on the organic light-emitting element; a color resin layer on the encapsulation layer; and a black resin layer on the encapsulation layer, wherein the auxiliary electrode is configured to be connected to the driving circuit, wherein the organic light-emitting element comprises: an anode electrode on the light guide body; an organic light-emitting layer on the anode electrode; and a cathode electrode on the organic light-emitting layer, wherein the organic light-emitting element comprises an opening portion and a reflection portion, wherein the color resin layer is positioned on the opening portion, and wherein light emitted from the organic light-emitting element is configured to be reflected in the reflection portion, be guided by the light guide body, and be emitted in an upper direction via the opening portion and the color resin layer.

In the bottom-emission method, commercialization is difficult due to limitations in the opening portion as the resolution increases. However, assuming that the aperture ratio, that is, the aperture area/pixel area, is about 20%, the surface area of the three-dimensional light guide body at an upper side of an opening portion can be configured to be more than three times the area of the opening portion. If the structure of the light guide body and reflector is optimized, the luminance and lifespan of the product can be improved by more than twice that of the existing product. Additionally, material costs can be reduced by eliminating the polarizer by increasing the contrast ratio to external light.

A further scope of applicability of the embodiment will become apparent from the detailed description that follows. However, since various changes and modifications within the spirit and scope of the embodiment can be clearly understood by those skilled in the art, it should be understood that the detailed description and specific embodiment, such as preferred embodiment, are given by way of example only.

### BRIEF DESCRIPTION OF THE DRAWINGS

FIG. 1A is a plan view showing a conventional organic light-emitting display device.
FIG. 1B is a plan view showing an organic light-emitting display device according to an embodiment.
FIG. 2 is a simplified schematic diagram of an example of the light guide body of FIG. 1B.
FIG. 3 is a cross-sectional view taken along line A-A' of the organic light-emitting display device of FIG. 1A.
FIG. 4 is a cross-sectional view showing a light guide body according to a first embodiment.
FIG. 5 shows the undercut structure of FIG. 4 in detail.
FIGS. 6 to 11 are examples of various three-dimensional structures of a light guide body.
FIGS. 12 to 14 are cross-sectional views showing other examples of modifications to the light guide body according to the first embodiment.
FIG. 15 is a flowchart explaining a manufacturing method of an organic light-emitting display device according to the first embodiment.
FIGS. 16 to 27 are cross-sectional views showing a method of manufacturing an organic light-emitting display device according to the first embodiment.
FIG. 28 is a cross-sectional view showing an organic light-emitting display device according to a second embodiment.
FIG. 29 is a flowchart explaining the manufacturing method of the organic light-emitting display device according to the second embodiment.

The sizes, shapes, dimensions, etc. of elements shown in the drawings can differ from actual ones. In addition, even if the same elements are shown in different sizes, shapes, dimensions, etc. between the drawings, this is only an example on the drawing, and the same elements have the same sizes, shapes, dimensions, etc. between the drawings.

### DETAILED DESCRIPTION OF EMBODIMENTS

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

Hereinafter, the embodiments will be described in detail with reference to the drawings.

The organic light-emitting display device according to the embodiment can comprise a white organic light-emitting element, but is not limited thereto. For example, a white organic light-emitting element can have a tandem structure in which two or more stacks comprising two or more light-emitting layers that emit white light are stacked vertically. Alternatively, the organic light-emitting display device according to the embodiment can comprise an organic light-emitting element comprising a red organic light-emitting layer, a green organic light-emitting layer, and a blue organic light-emitting layer in a side-by-side structure.

The organic light-emitting display device can be divided into a bottom-emission (BE) structure and a top-emission (TE) structure depending on the direction of light emission. Hereinafter, the description is limited to an organic light-emitting display device having a bottom-emission structure, but the embodiment can be equally applied to an organic light-emitting display device having a top-emission structure.

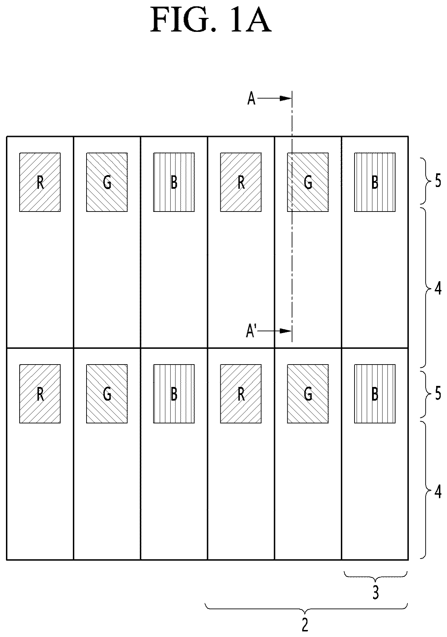

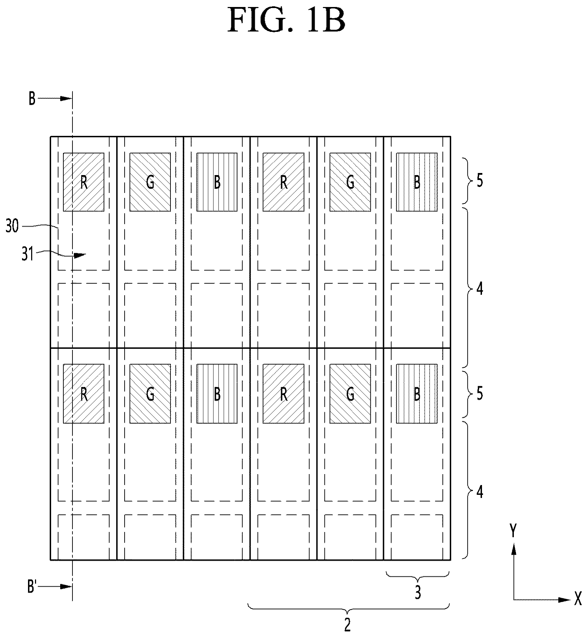

FIG. 1A is a plan view showing a conventional organic light-emitting display device. FIG. 1B is a plan view illustrating an organic light-emitting display device according to an embodiment.

As shown in FIGS. 1A and 1B, the pixel 2 can have a stripe structure composed of red, green, and blue subpixels 3.

Unlike the conventional device (FIG. 1A), the organic light-emitting display device according to the embodiment (FIG. 1B) can be provided with a light guide body 310.

As shown in FIG. 1B, the organic light-emitting display device according to the embodiment can apply a white organic light-emitting element and the pixel 2 can have a stripe structure composed of red, green, and blue subpixels 3. For example, in the case of 27-inch UHD resolution, the size of the pixel is a square of 160 micrometers, and the subpixel 3 can have a rectangle with a short side of 53.3 micrometers and a long side of 160 micrometers, but is not limited thereto. When the bottom-emission structure is applied, the aperture ratio can be at least 20% or more. The aperture ratio can be the area of the opening portion 5/the area of the pixel 2.

As shown in FIG. 1B, the organic light-emitting display device according to the embodiment can comprise a plurality of pixels 2. Each of the plurality of pixels 2 can comprise a plurality of subpixels 3. The plurality of subpixels 3 can be arranged, for example, in the order of red subpixel, green subpixel, and blue subpixel along the X-axis direction, but is not limited thereto. Each of the plurality of subpixels 3 can have a stripe structure along the Y-axis direction. For example, each of the plurality of subpixels 3 can emit different color light along the X-axis direction, but can emit the same color light along the Y-axis direction.

The organic light-emitting display device according to the embodiment can comprise a plurality of opening portions 5. At least one opening portion 5 can be located in the subpixel 3. The remaining area excluding the opening portion 5 can be the driving circuit portion 4.

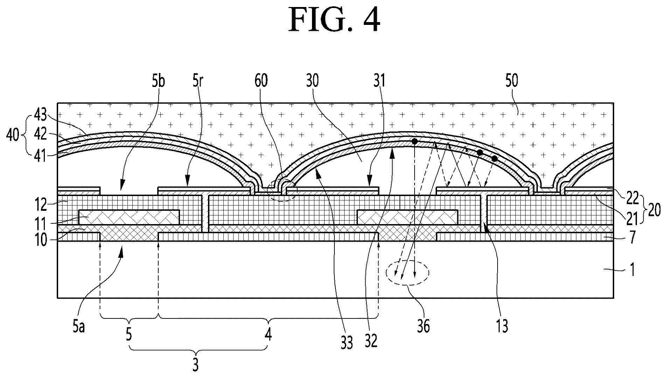

The subpixel 3 can comprise a driving circuit portion 4 and an opening portion 5. The driving circuit portion 4 can be located not only in the subpixel 3 but also between adjacent subpixels 3. The driving circuit portion 4 can be referred to as a driving circuit area, and the opening portion 5 can be referred to as an opening portion. For example, the area corresponding to the opening portion 5 can be defined as the first area, and the area corresponding to the driving circuit portion 4 can be defined as the second area. The driving circuit portion 4 can comprise a driving circuit (7 in FIG. 4) equipped with various circuit devices for driving each subpixel 3, such as transistors, capacitors, and wiring. The first area excluding the second area corresponding to the driving circuit portion 4 can become the opening portion 5. The transistor of the driving circuit 7 can comprise a silicon-based or oxide-based semiconductor material.

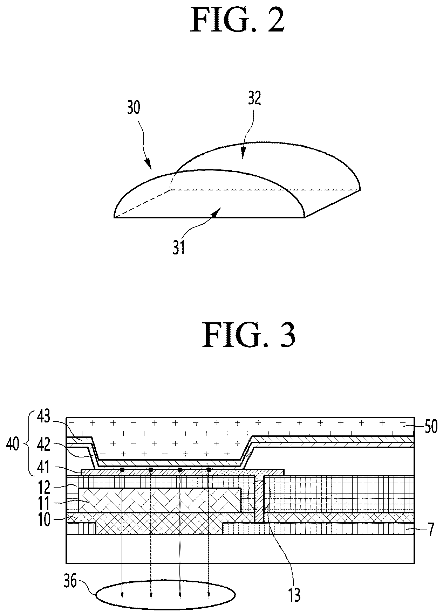

FIG. 2 is a simplified schematic diagram of an example of the light guide body of FIG. 1B.

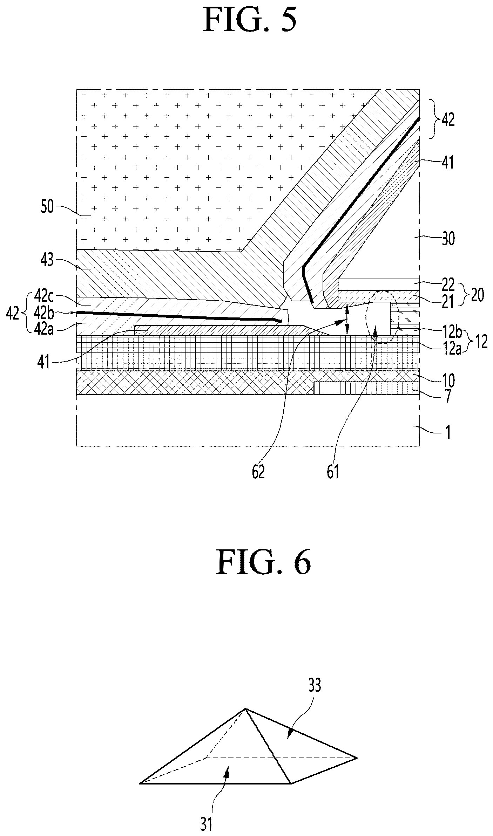

Referring to FIGS. 1B and 2, a light guide body 30 having a three-dimensional structure can be disposed on the opening portion 5 and the driving circuit portion 4. The light guide body 30 can be called a light guide structure, a light guide pattern, a light direction control member, etc. The size (or area) of the lower surface 31 of the light guide body 30 can be smaller than the size (or area) of the subpixel 3 and greater than the size (or area) of the opening portion 5. The opening portion 5 can be located at the central portion of the lower surface 31 of the light guide body 30, but be located biased away from the central portion of the lower surface 31 of the light guide body 30 depending on the shape of the three-dimensional structure of the light guide body 30. Depending on the arrangement structure of the subpixel 3 within the pixel 2, the lower surface 31 of the light guide body 30 can have various shapes such as square, rectangular, octagonal, circular, oval, etc. The structure of the light guide body 30 can also have various three-dimensional shapes depending on the shape of the lower surface 31 and the upper surface 32 of the light guide body 30, and FIGS. 6 to 11 show the structure of the light guide body 30. As shown in FIGS. 6 to 11, the light guide body 30 can have a lower surface 31. The light guide body 30 can have an upper surface 32 and/or a side surface 33. Here, the upper surface 32 is the opposite surface of the lower surface 31 and can have a straight surface or a round surface. The round surface can be formed not only on the upper surface 32 but also on the lower surface 33. The side surface 33 is a surface located between the lower surface 31 and the upper surface 32, and can have an inclined or rounded surface with respect to the lower surface 31.

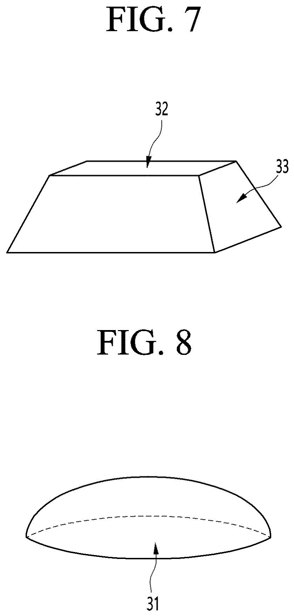

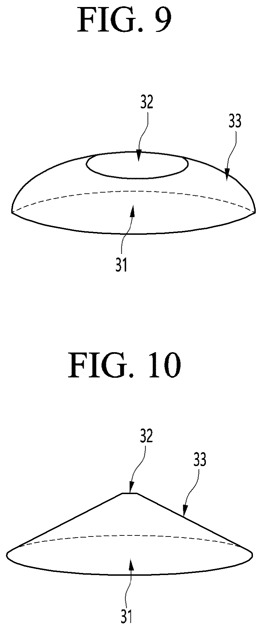

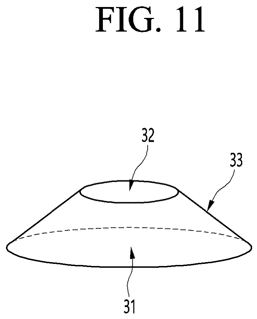

For example, the structure of the light guide body 30 is a four-pyramid (FIG. 6), a four-frustum of pyramid (FIG. 7), an ellipsoid cap (FIG. 8), a frustum of ellipsoid cap (FIG. 9), a circular cone (FIG. 10), a truncated circular cone (FIG. 11), etc.

In order to increase the light extraction effect, it can be effective to ensure that the center of the opening portion 5 coincides with the center of the light guide body 30.

FIG. 3 is a cross-sectional view taken along line A-A' of the organic light-emitting display device of FIG. 1A.

As shown in FIG. 3, an optical path 36 can be formed through which the light generated by the organic light-emitting element 40 is emitted through the color resin layer 11, the substrate 1, etc. in the lower direction.

FIG. 4 is a cross-sectional view showing a light guide body according to a first embodiment. For example, FIG. 4 is a cross-sectional view taken along line B-B' of the organic light-emitting display device of FIG. 1B.

Referring to FIGS. 1B and 4, the organic light-emitting display device according to the embodiment can comprise a substrate 1, a driving circuit 7, a protective layer 10, a color resin layer 11, and a planarization layer 12, an auxiliary electrode 20, a light guide body 30, an organic light-emitting element 40, an encapsulation layer 50, etc. The organic light-emitting display device according to an embodiment can comprise more or fewer components than these.

A driving circuit portion 4 and a plurality of opening portions 5 can be defined on the substrate 1. For example, a subpixel 3 can comprise at least one opening portion 5. The remaining area of the subpixel 3 excluding the opening portion 5 can be the driving circuit portion 4. The driving circuit 7 can be formed in the driving circuit portion 4 and be not formed in the opening portion 5. The driving circuit portion 4 can comprise a transistor, a capacitor, wiring, etc. The driving circuit portion 4 can be an area for defining the opening portion 5. That is, the remaining area excluding the opening portion 5 can be the driving circuit portion 4.

The protective layer 10 can be disposed on the driving circuit 7, the color resin layer 11 can be disposed on the protective layer 10, and the planarization layer 12 can be disposed on the color resin layer 11.

The auxiliary electrode 20 can be disposed on the planarization layer 12. The auxiliary electrode 20 can be connected to the driving circuit 7 through a through hole 13 of the planarization layer 12 and the protective layer 10. For example, the auxiliary electrode 20 can be electrically connected to a drain electrode (or source electrode) of the transistor of the driving circuit 7.

The auxiliary electrode 20 can have a double or triple structure. For example, the auxiliary electrode 20 has a double or triple structure comprising a first metal film 21, a second metal film 22, etc. The first metal film 21 can be connected to the drain electrode of the transistor of the driving circuit 7 through the through hole 13. The second metal film 22 can be made of a metal with excellent reflective properties. Light is reflected by the second metal film 22 and emitted through the light guide body 30 and the opening portion 5 in the lower direction, thereby improving light extraction efficiency.

The light guide body (30, LGB) can be disposed on the auxiliary electrode 20. The organic light-emitting element 40 can be disposed on the light guide body 30. The encapsulation layer 50 can be disposed on the organic light-emitting element 40.

The driving circuit 7 comprising a transistor, a capacitor, wiring, etc. can be formed on the substrate 1. The driving circuit 7 can be formed using a semiconductor process. The opening portion 5 can comprise an opening portion 5a (hereinafter referred to as a first opening portion). The first opening portion 5a can be defined by the driving circuit 7. That is, the area in each subpixel 3 where the driving circuit 7 is not formed can be defined as the first opening portion 5a. The size of the first opening portion 5a can be less than or equal to the size of the opening portion 5. For example, light can travel to the substrate 1 through the first opening portion 5a. For example, light can be blocked by the driving circuit 7 and may not travel to the substrate 1. The driving circuit 7 can comprise a transistor, a capacitor, wiring, etc. The transistor can comprise a silicon-based or oxide-based transistor. The transistor can comprise both a silicon-based transistor and an oxide-based transistor. In this instance, a switching transistor, for example, a scan transistor, can comprise an oxide-based transistor, and a driving transistor can comprise a silicon-based transistor.

The protective layer 10 can be made of an inorganic film. For example, the protective layer 10 can be formed of a silicon oxide film (SiOx), a silicon nitride film (SiNx), or a multilayer thereof.

The color resin layer 11 can be formed of a color filter material comprising pigment in the resin.

For example, the planarization layer 12 can be composed of an organic film such as acrylic resin, epoxy resin, phenol resin, polyamide resin, or polyimide resin. The planarization layer 12 can have a multiple structure of an organic film and an inorganic film such as a silicon oxide film (SiOx), a silicon nitride film (SiNx), etc.

The auxiliary electrode 20 can be disposed between the planarization layer 12 and the light guide body 30. The auxiliary electrode 20 can be connected to the drain electrode of the transistor of the driving circuit 7 through the through hole 13 of the planarization layer 12 and the protective layer 10. The auxiliary electrode 20 can have a function of electrically connecting the anode electrode 41 of the organic light-emitting element 40 to the driving circuit 7 and a function of reflecting a part of the light emitted from the organic light-emitting element 40. For example, the auxiliary electrode 20 can comprises a first layer comprising Ti and Mo to improve contact resistance characteristics with the drain electrode of the transistor, and a second layer comprising Ag, Ag alloy, or Al, which is a reflective metal with excellent reflection properties, on the first layer. A third layer such as ITO or IZO can be further included on the second layer to ensure fairness and reliability. For example, the auxiliary electrode 20 has a triple structure of ITO / (Ag or Ag alloy or Al) / (Ti or Mo) or a double structure of (Ag or Ag alloy or Al) / (Ti or Mo).

The auxiliary electrode 20 can comprise an opening portion 5b (hereinafter referred to as a second opening portion) and a reflection portion 5r. The reflection portion 5r can surround the second opening portion 5b.

The second opening portion 5b can be an area in which the auxiliary electrode 20 is not formed. The reflection portion 5r can be an area where light is reflected and can be an area where the second metal film 22 of the auxiliary electrode 20 is formed. The size (or area) of the second opening portion 5b can be less than or equal to the size (or area) of the opening portion 5. Light can be reflected into the light guide body 30 by the reflection portion 5r of the auxiliary electrode 20.

For example, light can travel to the substrate 1 through the second opening portion 5b, the color resin layer 11, and the first opening portion 5a. For example, the size (or area) of the color resin layer 11 can be greater than the size (or area) of the first opening portion 5a or the second opening portion 5b. Accordingly, even if the light passes through the first opening portion 5a or the second opening portion 5b in an oblique direction, the light can always passe through the color resin layer 11, so that light of a desired color can be emitted.

Meanwhile, the first opening portion 5a, the color resin layer 11, and the second opening portion 5b can overlap vertically. The centers of the first opening portion 5a, the color resin layer 11, and the second opening portion 5b can coincide with each other, but is not limited thereto.

The light guide body 30 can be disposed on the auxiliary electrode 20. The light guide body 30 can be made of an organic film. For example, the light guide body 30 can be formed of acrylic or polyimide resin. For example, the light guide body 30 can be formed of a color filter material such as red, green, or blue in which pigment is dispersed in a resin. When the light guide body 30 is made of a color filter material, the color resin layer 11 can be omitted, but is not limited thereto.

Meanwhile, using the etch selectivity between the material selected for the light guide body 30 and the material of the auxiliary electrode 20, the auxiliary electrode 20 can be patterned using the light guide body 30 as a mask. Accordingly, the auxiliary electrode 20 can be patterned to have the same shape and size as a lower surface 31 of the light guide body 30. As the resolution increases, the alignment tolerance between films affects yield. Accordingly, the auxiliary electrode 20, which acts as a reflective film, and the light guide body 30, which plays an optically important role, are aligned through self-alignment, so that it is also effective in improving the performance of products, namely an organic light-emitting display device.

The size (or area) of the auxiliary electrode 20 and the size (or area) of the lower surface 31 of the light guide body 30 can be different. Depending on whether an ashing process is added, the type of etching, etc., the size of the auxiliary electrode 20 can be smaller or greater than the size of the lower surface 31 of the light guide body 30 by less than 2 µm, and it can be formed to protrude or recess horizontally at the same distance from all four corners of the light guide body 30.

The organic light-emitting element 40 can be disposed on the light guide body 30. The organic light-emitting element 40 can comprise an anode electrode 41, a plurality of organic light-emitting layers 42, a cathode electrode 43, etc. The plurality of organic light-emitting layers 42 can be formed on the anode electrode 41, and the cathode electrode 43 can be formed on the organic light-emitting layer 42. The anode electrode 41 and the organic light-emitting layer 42 can be separated between subpixels 3. As shown in FIG. 1B, the organic light-emitting layer 42 can have a stripe structure that is continuous without being separated between subpixels 3 along the Y-axis direction. The cathode electrode 43 can be commonly disposed in all pixels 2 or all subpixels, but is not limited thereto.

The organic light-emitting element 40 can surround the light guide body 30. Specifically, the anode electrode 41 can cover the entire surface of the light guide body 30. The anode electrode 41 can be formed of a transparent conductive film (TCO) such as ITO or IZO that can transmit light.

The anode electrode 41 can be connected to the auxiliary electrode 20 at the end of a corner of the light guide body 30.

The anode electrode 41 can be formed using a sputtering method to have good step coverage characteristics.

The anode electrode 41 can be connected to an upper surface of a protruded portion of the auxiliary electrode 20. As shown in FIG. 4, when the end of the auxiliary electrode 20 protrudes horizontally from the end of the light guide body 30, the anode electrode 410 can be connected to the side and upper surfaces of the end of the auxiliary electrode 20. For example, the anode electrode 41 can be connected to the upper and side surfaces of the second metal film 22 protruding from the light guide body 30. For example, when the auxiliary electrode 20 does not protrude horizontally, the anode electrode 41 can be connected to the side surface of the auxiliary electrode 20.

Meanwhile, the light emitted from the organic light-emitting element 40, specifically the organic light-emitting layer 42, can be reflected in the reflection region 5r of the auxiliary electrode 20, and multiple reflections can be caused by the interface between the light guide body 30 and the anode electrode 41, the interface between the anode electrode 41 and the organic light-emitting layer 42, the interface between the organic light-emitting layer 42 and the cathode electrode 43, etc. That is, light can be reflected to the light guide body 30 by the auxiliary electrode 20 on a lower side of the light guide body 30 and the organic light-emitting element 40 on an upper side of the light guide body 30, and an optical path 36 through which a greater amount of light is emitted in the lower direction through the second opening portion 5b, the first opening portion 5a, the first substrate 1, etc. can be formed by the light guide body 30. Accordingly, as a greater amount of light is emitted in the lower direction, light extraction efficiency can be significantly increased and luminance can be improved.

The encapsulation layer 50 can be disposed on the organic light-emitting element 40. The encapsulation layer 50 can serve to prevent moisture or oxygen from penetrating into the organic light-emitting layer 42. To this end, the encapsulation layer 50 can comprise at least one inorganic film and at least one organic film. For example, it can have a triple structure consisting of a first inorganic film, a resin film, and a second inorganic film. Here, the first inorganic film, the resin film, and the second inorganic film can be called a first encapsulation film, a second encapsulation film, and a third encapsulation film, respectively.

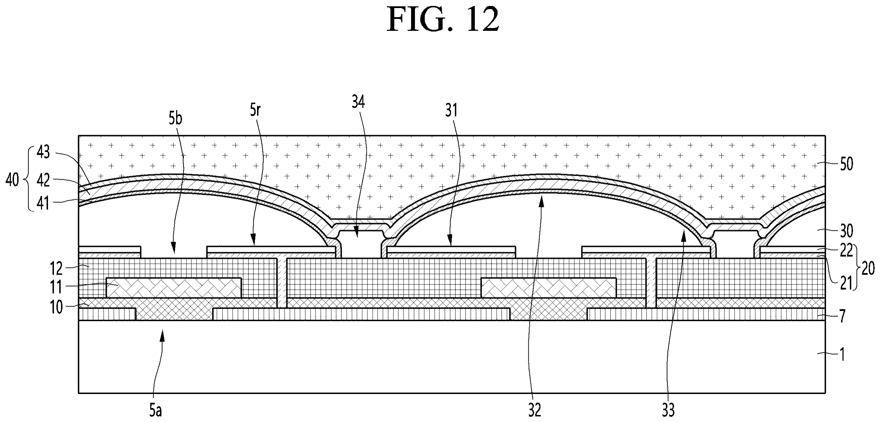

Meanwhile, as shown in FIG. 4, the organic light-emitting display device may not include a pixel definition layer (34, PDL in FIGS. 12 to 14).

There is a problem in that if the anode electrode 41 is thick, current is concentrated due to the etched step differences at the corners of the anode electrode 41 during long-term operation, an electrical short circuit due to vertical leakage current (VCL) occurs through the organic light-emitting layer 42 between the anode electrode 41 and the cathode electrode 43, resulting in point defects. To solve this problem, the pixel definition layer 34 can be formed to surround the corner area of the anode electrode 41 between adjacent subpixels 3.

Meanwhile, in the embodiment, even if the PDL 34 is not provided, in order to prevent point defects, the thickness of the anode electrode 41 can be set to 50 nanometers or less, and the anode electrode 41 can be connected only to the etched end surface, that is, the side surface, of the auxiliary electrode 20, so that the step difference formed in the anode electrode 41 can be removed.

FIG. 5 shows the undercut structure of FIG. 4 in detail.

As shown in FIGS. 4 and 5, the planarization layer 12 can be composed of multiple films. For example, the planarization layer 12 can have a double structure of a resin film 12a and an inorganic film 12b. An undercut structure 60 can be formed by using the planarization layer 12. For example, by using the inorganic film 12b having an etch rate greater than that of the resin layer 12a, the inorganic film 12b can be etched to form the undercut structure 60. The undercut structure 60 can be connected to the auxiliary electrode 20 in the anode electrode 41 at the film forming stage, but can be formed along the perimeter of the lower side of the corner of the light guide body 30, that is, the perimeter of the lower side of the auxiliary electrode 20.

After the undercut structure 60 is formed, if the PDL 34 is not added,
the anode electrode 41 may be not formed along the undercut inner wall 61 of the undercut structure 60, that is, along the side surface of the inorganic film 12b of the planarization layer 12 due to the undercut structure 60, so that the anode electrode 41 can be disconnected. After the undercut structure 60 is formed, if the PDL 34 is not added, a layer made of a low-resistance material among the organic light-emitting materials, for example, a charge generation layer, can be also be disconnected in the step of forming the organic light-emitting element 40. Accordingly, lateral current leakage (LCL) between subpixels can be reduced.

FIGS. 12 to 14 are cross-sectional views showing other examples of modifications to the light guide body according to the first embodiment. For example, as shown in FIGS. 12 to 14, the organic light-emitting display device can comprise a PDL 34.

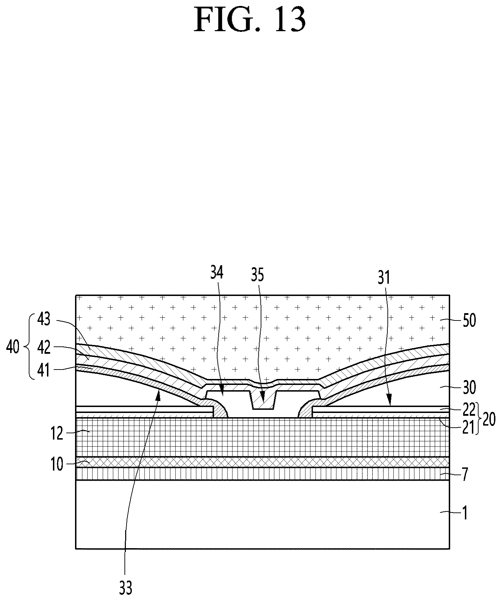

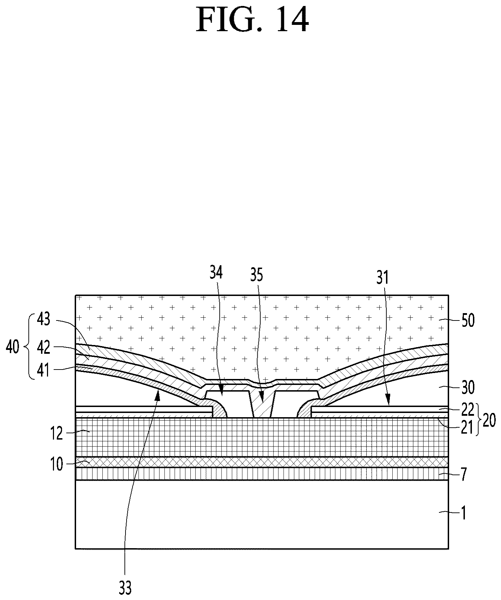

Referring to FIGS. 12 to 14, in the embodiment, the PDL 34 can be added if it meets the design goal of the product and is necessary for the process. As shown in FIG. 12, after the anode electrode 41 is formed in each subpixel, the PDL 34 can be formed between the subpixels. By forming a trench 35 in the PDL 34 as shown in FIGS. 13 and 14, the lateral leakage current can be reduced. The trench 35 can be called a via or a through hole. One or more trenches 35 can be provided, and the width thereof can be 200 nanometers to 300 nanometers, which is the sum of the thicknesses of the first organic light-emitting stack and the first charge generation layer, and the depth thereof can be more than twice the width thereof.

As shown in FIG. 14, the trench 35 can be formed by passing through the PDL 34. In this instance, the organic light-emitting layer 42 can be in contact with the upper surface of the planarization layer 12 through the trench 35.

Meanwhile, as shown in FIGS. 4 and 12 to 14, the organic light-emitting layer 42 and the cathode layer 143 can be disposed on the anode electrode 41, so that an organic light-emitting element 40 can be constructed. The organic light-emitting layer 42 can comprise one or more of a hole injection layer, a hole transport layer, a light-emitting layer, an electron transport layer, and an electron injection layer. In this instance, when voltage is applied to the anode electrode 41 and the cathode electrode 43, holes and electrons can move to the light-emitting layer through the hole transport layer and electron transport layer, respectively, so that the holes and electrons can combine with each other in the light-emitting layer to emit light.

The organic light-emitting layer 42 can be a white light-emitting layer that emits white light. In this instance, the organic light-emitting layer 42 can have a tandem structure comprising two or more vertically stacked organic light-emitting stacks. Each of the organic light-emitting stacks can comprise a hole transport layer, at least one light-emitting layer, an electron transport layer, etc. Additionally, a charge generation layer can be formed between the organic light-emitting stacks. The charge generation layer can be composed of a pair of an n-type charge generation layer (nCGL) located adjacent to a lower organic light-emitting stack and a p-type charge generation layer (pCGL) located between the n-type charge generation layer and an upper organic light-emitting stack. The n-type charge generation layer can inject electrons into the lower organic light-emitting stack, and the p-type charge generation layer can inject holes into the upper organic light-emitting stack. The n-type charge generation layer can comprise an organic film doped with an alkali metal such as Li, Yb, Na, K, or Cs, or an alkaline earth metal such as Mg, Sr, Ba, or Ra. The p-type charge generation layer can be formed by doping the hole transport layer (HTL) with a dopant.

The cathode electrode 43 can be disposed on the organic light-emitting layer 42. The cathode electrode 43 can be a common layer commonly formed in all pixels. The cathode electrode 43 can comprise aluminum Al, an aluminum alloy, silver Ag, an alloy of silver Ag, etc. that can reflect light. The cathode electrode 43 can be formed to be thicker than 100 nanometers to ensure faithful total reflection of light during bottom-emission and at the same time prevent the voltage drop of the power supply due to the resistance of the cathode electrode 43. As the thickness of the cathode electrode 43 increases, the process margin of the undercut structure (60 in FIG. 4) increases, so that an organic light-emitting display device can be easily manufactured.

The encapsulation layer 50 can be disposed on the organic light-emitting element 40. The encapsulation layer 50 serves to prevent moisture or oxygen from penetrating into the organic light-emitting layer 42. To this end, the encapsulation layer 50 can comprise at least one inorganic film and at least one organic film. For example, it can have a triple structure consisting of a first inorganic film, a resin layer, and a second inorganic film.

A part of the light emitted from the organic light-emitting element 40 disposed along the perimeter of the upper surface 32 and the side surface 33 of the light guide body 30 can pass through the second opening portion 5b. Another part of the light emitted from the organic light-emitting element 40 can be incident on the second metal film 22 of the auxiliary electrode 20 and be reflected again by the second metal film 22. The reflected light can be incident on the cathode electrode 43 of the organic light-emitting element 40 through the light guide body 3 and then reflected again. This process is performed repeatedly so that light can continuously be emitted through the opening portion 5. Accordingly, light extraction efficiency can be dramatically increased and luminance can be improved.

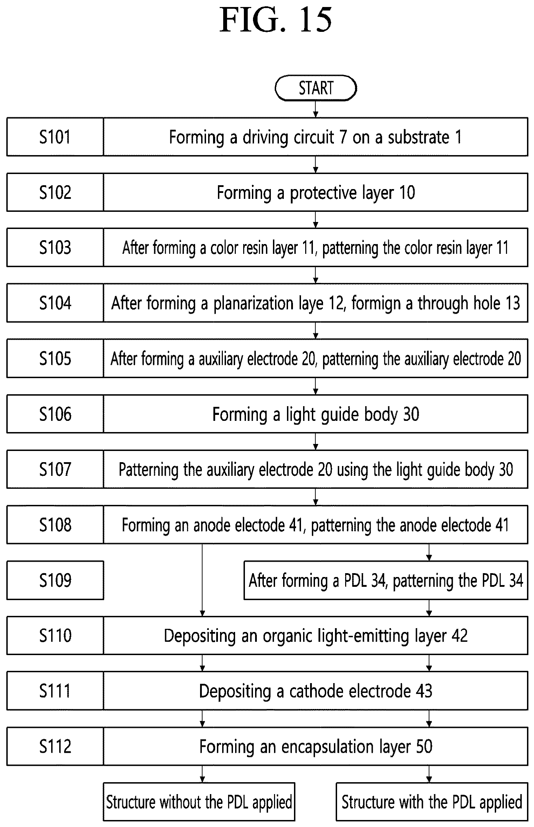

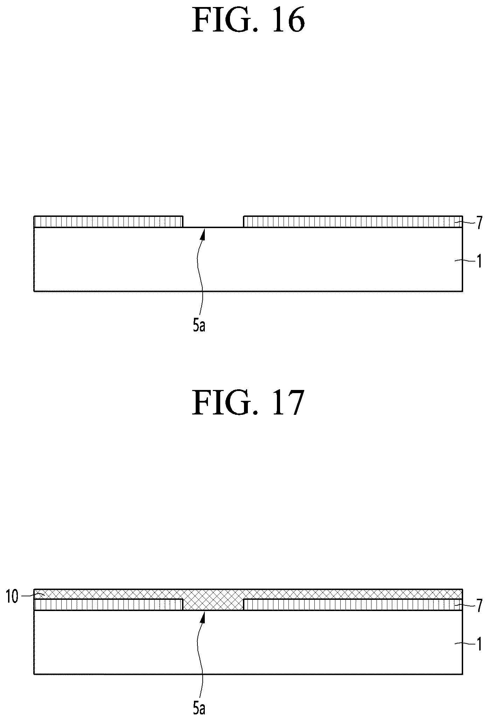

FIG. 15 is a flowchart explaining a manufacturing method of an organic light-emitting display device according to the first embodiment. FIGS. 16 to 27 are cross-sectional views showing a method of manufacturing an organic light-emitting display device according to the first embodiment.

The manufacturing method for each step of FIG. 15 will be described in detail with reference to the cross-sectional structures of FIGS. 16 to 27.

[S101 in FIG. 15] As shown in FIG. 16, the driving circuit 7 comprising a transistor, a capacitor, wiring, etc. can be formed on the substrate 1. The substrate 1 can be made of glass, etc. The transistor can be formed of, for example, a silicon-based semiconductor material, an oxide-based semiconductor material, etc.

The first opening portion 5a can be formed by an area where the driving circuit 7 is not formed. Accordingly, a bottom-emission type optical path in which light is emitted to the first substrate 1 through the first opening portion 5a can be formed.

[S102 in FIG. 15] As shown in FIG. 17, the protective layer 10 can be formed on the driving circuit 7. The protective layer 10 can contact the upper surface of the substrate 1 through the first opening portion 5a. The protective layer 10 can be composed of an inorganic film or a multilayer composed of an inorganic film or an organic film. The inorganic film can comprise, for example, a silicon oxide film (SiOx), a silicon nitride film (SiNx), etc.

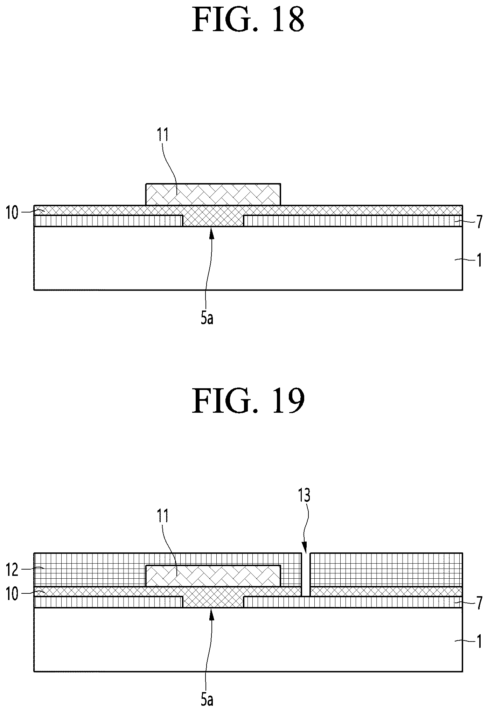

[S103 in FIG. 15] As shown in FIG. 18, a color resin film can be applied on the protective layer 1 and then patterned to form the color resin layer 11. For example, a red color resin layer can be formed in a red subpixel, a green resin layer can be formed in a green subpixel, and a blue color resin layer can be formed in a blue subpixel, but are not limited thereto. When a pixel is composed of RGBW subpixels, a transparent resin layer made of a transparent resin film can be formed in the white subpixel.

The color resin layer 11 can have a size that covers at least the first opening portion 5a. For example, the size (or area) of the color resin layer 11 can be greater than the size (or area) of the first opening portion 5a. That is, an edge area of the color resin layer 11 can vertically overlap the driving circuit 7.

[S104 in FIG. 15] As shown in FIGS. 4, 5, and 19, the planarization layer 12 can be formed on the color resin layer 11 and then patterned to form a through hole 13. The through hole 13 can be formed in the color resin layer 11 and the protective layer 10. The through hole 13 can be formed on a side portion of the color resin layer 11 adjacent to the color resin layer 11. The auxiliary electrode can be connected to the drain electrode of the transistor of the driving circuit 7 through the through hole 13. In order to apply the undercut structure 60, the planarization layer 12 can comprise a resin layer 12a, an inorganic film 12b, etc. The inorganic film 12b can be made of a material with excellent etch selectivity with the resin layer 12a and/or the auxiliary electrode. For example, the etch rate of the inorganic film 12b can be greater than that of the resin layer 12a and/or the auxiliary electrode. For example, the inorganic film 12b can be made of a silicon oxide film, a silicon nitride film, etc.

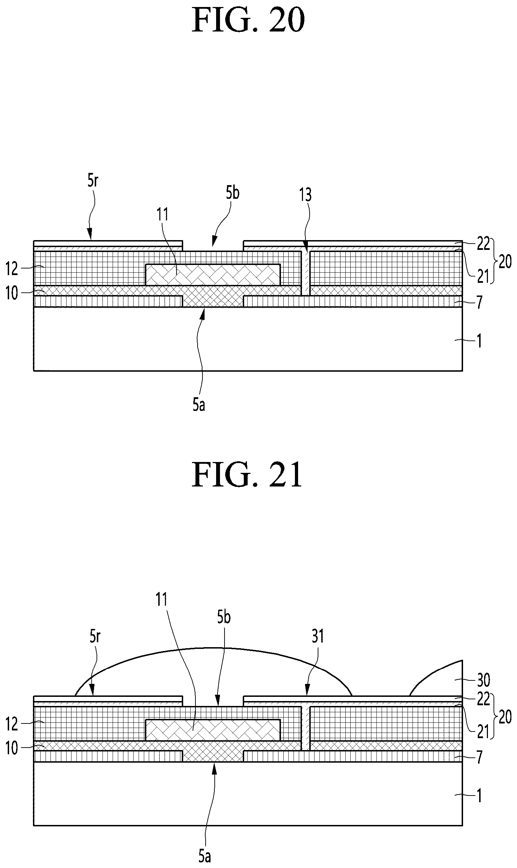

[S105 in FIG. 15] As shown in FIGS. 5 and 20, the auxiliary electrode 20 can be formed on the planarization layer 12 and then patterned to form the second opening portion 5b. The area where the auxiliary electrode 20 is removed can be formed as a second opening portion 5b. For example, the second opening portion 5b can be positioned on the color resin layer 11. For example, the second opening portion 5b can be formed to correspond to the first opening portion 5a. For example, the area of the second opening portion 5b can be the same as the area of the first opening portion 5a, but is not limited thereto.

The auxiliary electrode 20 can be connected to the drain electrode of the transistor of the driving circuit 7 through the through hole 13.

The color resin layer 11 can have a size that covers at least the second opening portion 5b. For example, the area of the color resin layer 11 can be greater than the area of the second opening portion 5b. That is, an edge area of the color resin layer 11 can vertically overlap the auxiliary electrode 20.

For example, a first metal film 21 such as Ti or Mo can be applied to a thickness of 20 nanometers or more using a sputtering equipment, and a second metal film 22 such as Ag, Ag alloy, or Al with good reflective performance can be applied on the upper side of the first metal film 21 to a thickness of 80 nanometers or more, so that an auxiliary electrode 20 can be formed. For fairness and reliability, a transparent conductive film such as ITO or IZO can be applied on an upper side of the second metal film 22 to a thickness of 50 to 100 nanometers, but is not limited thereto. The first metal film can be a contact metal film, and the second metal film can be a reflective metal film.

[S106 in FIG. 15] As shown in FIG. 21, the light guide body 30 can be formed on the auxiliary electrode 20. The light guide body 30 can be made of transparent acrylic or polyimide resin. When forming the light guide body 30 thick, the light guide body 30 can be made of dry film resin (DFR). Alternatively, the light guide body 30 can be formed using a printing method depending on the resolution.

The lower surface 31 of the light guide body 30 can be in contact with the upper surface of the auxiliary electrode 20. The lower surface 31 of the light guide body 30 can contact the upper surface of the planarization layer 12 through the second opening portion 5b.

The light guide body 30 can be positioned on the color resin layer 11. The light guide body 30 can cover the entire area of the color resin layer 11. For example, the size (or area) of the light guide body 30 can be greater than the size (or area) of the color resin layer 11. The center of the light guide body 30 and the center of the color resin layer 11 can coincide, but is not limited thereto.

In addition, it can have various forms as shown in Figures 2 and 6 to 11. For example, the surface opposite to the lower surface 31 of the light guide body 30, that is, the upper surface 32 and/or the side surface 33, can have a round surface convex toward the upper direction or an angled surface.

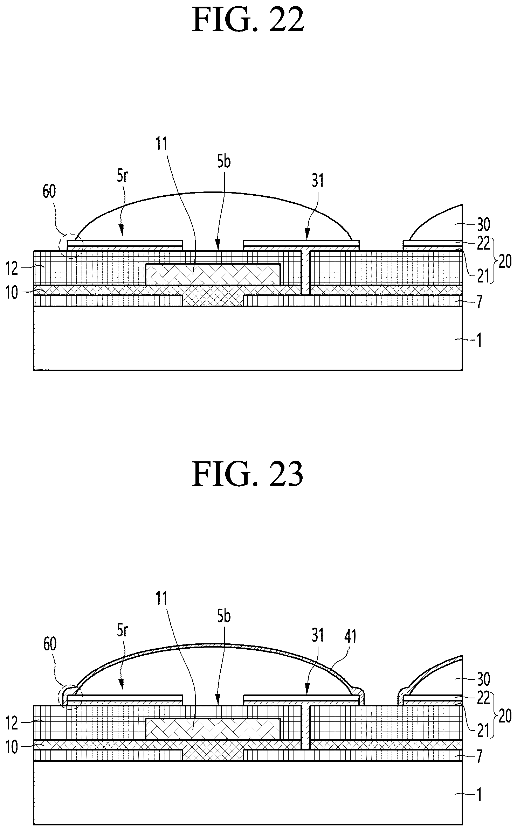

[S107 in FIG. 15] As shown in FIG. 22, the auxiliary electrode 20 can be patterned using the pattern of the light guide body 30 as a mask. Accordingly, the auxiliary electrode 20 can be patterned to have the same shape and size as the lower surface 31 of the light guide body 30. In addition, the auxiliary electrode 20 can be separated between subpixels through patterning of the auxiliary electrode 20.

Depending on the type and structure of the auxiliary electrode 20, wet etching, dry etching, or a combination of the two can be used, and an ashing process can be added.

A process can be added to form an undercut structure (60 in FIG. 4) in S107. For example, the light guide body 30 can be further patterned so that the end of the auxiliary electrode 20 can protrude horizontally from the light guide body 30, as shown in FIG. 22. In this instance, the size (or area) of the auxiliary electrode 20 can be greater than the size (or area) of the lower surface 31 of the light guide body 30. Meanwhile, as shown in FIG. 5, the undercut structure 60 can be formed by selectively etching the resin layer 12a, the inorganic film 12b, etc. of the planarization layer 12.

[S108 in FIG. 15] As shown in FIGS. 5 and 23, the anode electrode 41 can be formed on the light guide body 30 and the undercut structure 60 (FIG. 5) and then patterned. Accordingly, the anode electrode 41 can be separated between subpixels through patterning of the anode electrode 41.

The anode electrode 41 can be formed of a transparent conductive material such as ITO or IZO that can transmit light.

A photoresist pattern can be formed on the anode electrode 41. In order to remove the anode electrode 41 located between subpixels, the lower surface 31 of the light guide body can be covered with a photoresist pattern, focusing on the light guide body 30. The uncovered anode electrode 41 can be removed using wet etching to form the anode electrode 41 as shown in FIG. 23. Afterwards, the photoresist pattern can be removed.

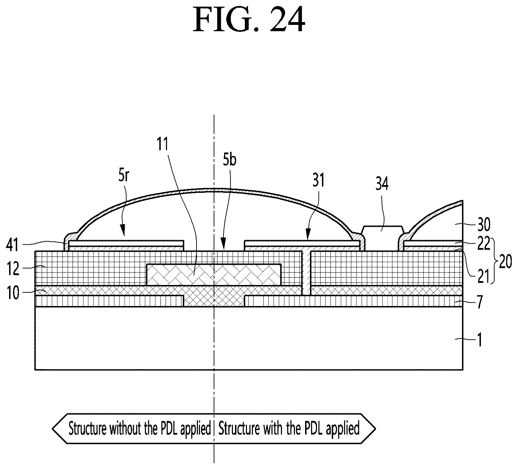

[S109 in FIG. 15] As shown in FIG. 24, the PDL 34 can be formed on the anode electrode 41 and then patterned, so that the PDL 34 can be formed between adjacent anode electrodes 41.

For convenience of explanation, FIGS. 24 to 27 show a cross-sectional structure with and without the PDL 34 applied.

In the embodiment, the PDL 34 can or may not be applied. The embodiment can also be in a mixed form where the PDL 34 is partially applied and the PDL 34 is partially not applied.

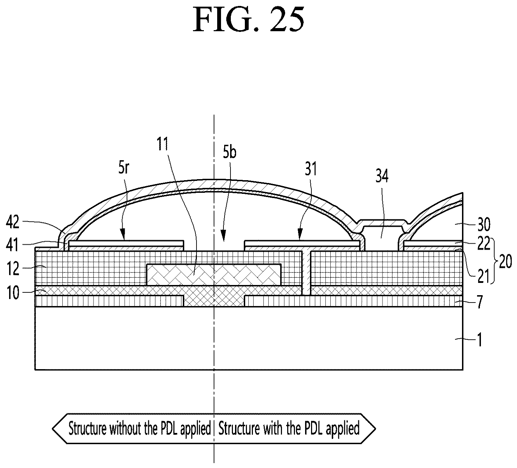

[S110 in FIG. 15] As shown in FIG. 25, the organic light-emitting layer 42 can be formed on the anode electrode 41. The organic light-emitting layer 42 can be a white light-emitting layer that emits white light. Accordingly, the organic light-emitting layer 42 can have a tandem structure comprising two or more organic light-emitting stacks. A charge generation layer can be formed between the organic light-emitting stacks. The charge generation layer 142b can be composed of a pair of an n-type charge generation layer and a p-type charge generation layer. Since the organic light-emitting layer 42 is formed by evaporation deposition, the step coverage characteristics are poor, the organic light-emitting layer 42 cannot be formed by penetrating into the undercut inner wall 61 of the undercut structure 60 shown in FIG. 5. Accordingly, the first organic light-emitting stack 42a and the first charge generation layer 42b can be formed to have disconnection portions at the entrance of the undercut structure 60. By disconnecting not only the anode electrode 41 but also the first charge generation layer 42b, which is a low-resistance material of the organic light-emitting layer 42, the influence of adjacent pixels due to leakage current flowing into the organic light-emitting layer 42 can be minimized.

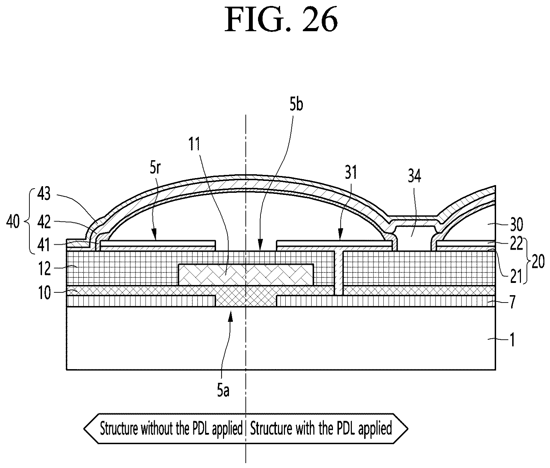

[S111 in FIG. 15] As shown in FIG. 26, the cathode electrode 43 can be formed on the organic light-emitting layer 42. Accordingly, the organic light-emitting element 40 can be composed of the anode electrode 41, the organic light-emitting layer 42, and the cathode electrode 43.

The cathode electrode 43 can be formed by depositing aluminum Al, Al alloy, or silver Ag using a vacuum deposition method. Since the cathode electrode 43 is a common electrode common to all pixels and the same voltage must be applied regardless of position, the cathode electrodes 43 formed in all pixels can be electrically connected. For stable power supply, the cathode electrode 43 can be formed sufficiently thick. To prevent the cathode electrode 43 from being disconnected by the undercut structure 60 shown in FIG. 4, the thicker the cathode electrode 43 is, the more advantageous it is. For example, the cathode electrode 43 can be formed to be about 100 to 300 nm, but is not limited thereto. It can be desirable to ensure that the height 62 of the undercut structure 60 does not exceed a certain height. For example, the cathode electrode 43 can be made no longer than 400 nm.

The embodiment can be an organic light-emitting display device having a bottom-emission structure, and the cathode electrode 43 can be formed sufficiently thick to about 100 nm. Therefore, compared to an organic light-emitting display device having a top-emission structure where the cathode electrode 43 has a thickness of 20 nm or less, a sufficient process margin can be secured when designing the undercut structure 60 in an organic light-emitting display device having a bottom-emission structure. It is sufficient to ensure that the undercut height (62 in FIG. 5) is at least 200 nm, which is the sum of the thickness of the anode electrode 41 (50 nm or less) and the thickness of the first organic light-emitting stack (150 nm or less). For example, if the undercut height 62 is 400 nm or less, the anode electrode 41 can be formed separated by the undercut structure 60, but the cathode electrode 43 can be formed without being separated.

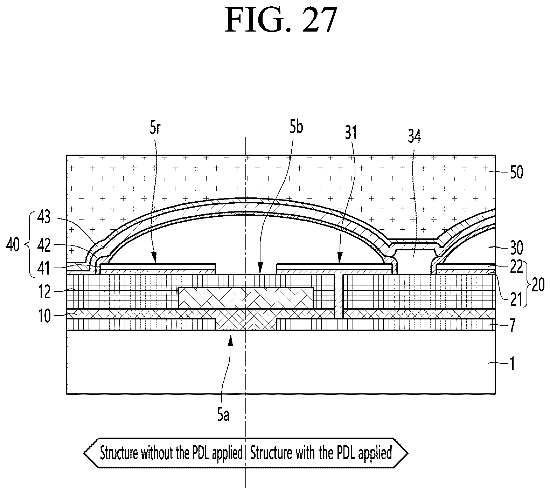

[S112 in FIG. 15] As shown in FIG. 27, the encapsulation layer 50 can be formed on the cathode electrode 43. The encapsulation layer 50 serves to prevent oxygen or moisture from penetrating into the organic light-emitting layer 42 and the cathode electrode 43. To this end, the encapsulation layer 50 can comprise at least one inorganic film and at least one organic film. For example, a silicon oxide film or a silicon nitride film formed by a PECVD method can be used as the inorganic film. For example, films deposited using ALD (Atomic Layer Deposition) or PECVD, or an alumina (Al2O3) film can be used as the inorganic film. Epoxy resin, acrylic resin, etc. can be used as the organic film. Another inorganic film can additionally be formed on top of the organic film.

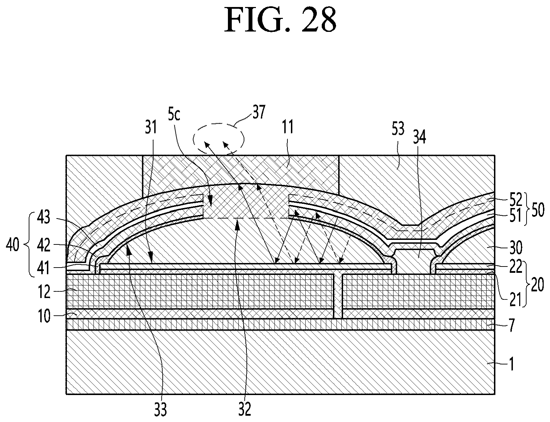

FIG. 28 is a cross-sectional view showing an organic light-emitting display device according to a second embodiment.

Referring to FIG. 28, the organic light-emitting display device according to the second embodiment can emit light using a top-emission method.

The organic light-emitting display device according to the second embodiment can comprise a plurality of pixels. The pixel can comprise red (R), green (G), and blue (B) subpixels or red (R), green (G), blue (B), and white (W) subpixels. A light guide body 30 having a three-dimensional structure can be disposed in each subpixel, and an organic light-emitting element 40, an encapsulation layer 50, etc. can be disposed on the light guide body 30. A color resin layer 11 and/or a black resin layer 53 can be disposed on the encapsulation layer 50.

An auxiliary electrode 20, a planarization layer 12, a protective layer 10, a driving circuit 7, a substrate 1, etc. can be disposed under the light guide body 30. The planarization layer 12 and the protective layer 10 can be disposed as one or both.

The light guide body 30 can be composed of transparent resin or an inorganic film on a transparent resin. The inorganic film can serve to prevent a decrease in the lifespan of the organic light-emitting element 40 due to diffusion of residual organic components from the transparent resin. The inorganic film can serve as an etch stopper in the removal process of the cathode electrode 43 in the opening portion 5c. The lower surface 31 of the light guide body 30 can have various shapes such as square, rectangular, octagonal, circular, oval, etc. The side surface 33 of the light guide body 30 can have a straight surface inclined with respect to the lower surface 31 or can have a round surface. The light guide body 30 can have a structure such as a frustum of pyramid, a frustum of ellipsoid cap, a truncated circular cone, etc.

The auxiliary electrode 20 can be electrically connected to the drain electrode of the transistor of the driving circuit 7 through the through hole 13 of the planarization layer 12 and the protective layer 10.

The auxiliary electrode 20 can have a triple structure composed of a first metal film, such as titanium Ti or molybdenum Mo, in contact with the driving circuit 7, a second metal film with good reflective performance, such as aluminum Al, silver Ag, or silver alloy, and a third metal film in contact with the anode electrode 41 and having transparency such as ITO or IZO.

The auxiliary electrode 20 can have a double structure a double structure consisting of a second metal film on a first metal film, or a second metal film and a third metal film. The auxiliary electrode 20 can have a single layer of the second metal film.

The anode electrode 41, the organic light-emitting layer 42, and the cathode electrode 43 can be disposed in that order on the light guide body 30, so that the organic light-emitting element 40 can be constructed. The anode electrode 41 can comprise a transparent conductive film such as ITO or IZO.

The organic light-emitting layer 42 can have a plurality of organic light-emitting stack structures. For example, the organic light-emitting layer 42 can have two-organic light-emitting stack structure, three-organic light-emitting stack structure, four-organic light-emitting stack structure, etc. The two-organic light-emitting stack structure can be composed of a first organic light-emitting stack, a first charge generation layer, and a second organic light-emitting stack. The three-organic light-emitting stack structure can be composed of a first organic light-emitting stack, a first charge generation layer, a second organic light-emitting stack, a second charge generation layer, and a third organic light-emitting stack. The first organic light-emitting stack, the second organic light-emitting stack, and the third organic light-emitting stack can each can comprise a hole injection layer, a hole transport layer, a light-emitting layer, an electron transport layer, and an electron injection layer.

The cathode electrode 43 can have a single layer of metal such as aluminum Al or Mg:Ag alloy, or a double layer structure combining single layers on the uppermost organic light-emitting stack among a plurality of organic light-emitting stacks. The cathode electrode 43 can be made of a metal film with a reflective function, and the anode electrode can be made of a transparent conductive film.

The organic light-emitting element 40 can comprise an opening portion 5c and a reflection portion. The opening portion 5c can be an area in which the cathode electrode 43 is not formed. In this instance, the lower surface of the encapsulation layer 50 can contact the upper surface of the organic light-emitting layer 42 in the opening portion 5c.

The opening portion 5c can be an area in which the cathode electrode 43 and the organic light-emitting layer 42 are not formed. In this instance, the lower surface of the encapsulation layer 50 can contact the upper surface of the anode electrode 41 in the opening portion 5c.

The opening portion 5c can be an area in which the cathode electrode 43, the organic light-emitting layer 42, and the anode electrode 41 are not formed. In this instance, the lower surface of the encapsulation layer 50 can contact the upper surface of the light guide body 30 in the opening portion 5c.

The size (or area) of the color resin layer 11 can be greater than the size (or area) of the opening portion 5c. Accordingly, even if the light passes through the opening portion 5c in an inclined direction, the light can always passe through the color resin layer 11, so that the desired color light can be emitted.

Unlike the first embodiment (FIG. 4), in the second embodiment (FIG. 28), an opening portion may not be formed in the driving circuit 7 or the auxiliary electrode 20. This is because light is emitted from the organic light-emitting element 40 or the light guide body 30 toward the upper direction in the top emission method, and an opening area is not required for light to be emitted in the lower direction.

Accordingly, the light emitted from the organic light-emitting element 40 can be reflected in the upper direction by the auxiliary electrode 20, and can be multiple-reflected at the interface between a plurality of layers within the organic light-emitting element 40. The reflected light can be continuously guided to the opening portion 5c by the light guide body 30, so that an optical path 37 can be formed to emitted to the opposite side of the substrate 1, that is, through the color resin layer 11.

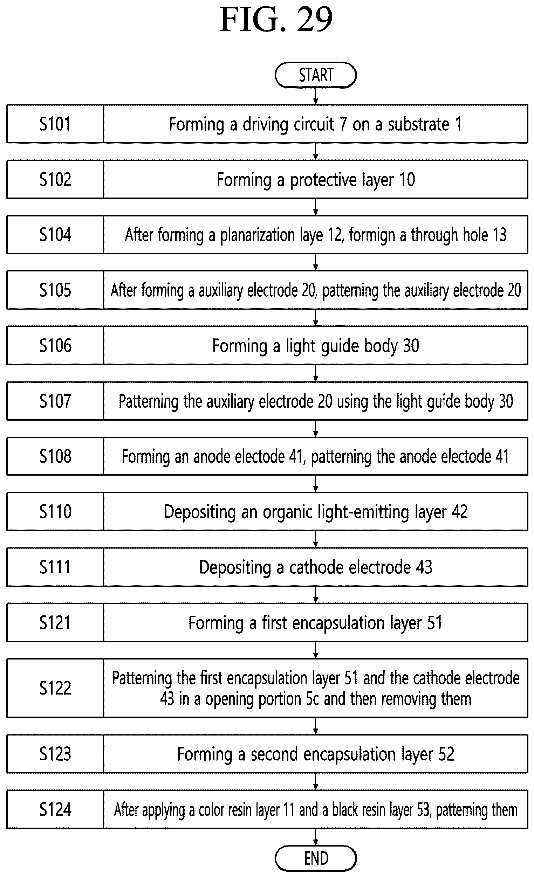

FIG. 29 is a flowchart explaining the manufacturing method of the organic light-emitting display device according to the second embodiment.

The description of the manufacturing method from S101 to S111 described above in the manufacturing method of the first embodiment (FIG. 15) is omitted, and only the process added to manufacture the organic light-emitting display device according to the second embodiment will be described.

[S121, S122, and S123 in FIG. 29] After an inorganic film is formed as the first encapsulation film 51 on the organic light-emitting element 40 and an organic film is continuously formed on the inorganic film, the organic film formed in the opening region 5c can be removed. Subsequently, since it is formed in the opening portion 5c using dry etching, the second encapsulation film 52 can be formed on the first encapsulation film 51 after the inorganic film and the cathode electrode 43 are removed. The first encapsulation film 51 can comprise one organic film on at least one inorganic film. For example, a silicon oxide film or a silicon nitride film formed by a PECVD method can be used as an inorganic film. For example, films deposited using ALD (Atomic Layer Deposition) or PECVD, or an alumina (Al2O3) film can be used as the inorganic film. Epoxy resin, acrylic resin, etc. can be used as the organic film. An inorganic film is formed as a second encapsulation film 52 on the organic film. Accordingly, the encapsulation layer 50 can be formed by the first encapsulation film 51 and the second encapsulation film 52.

[S124 in FIG. 29] The color resin layer 11 and the black resin layer 53 can be applied to the upper side of the encapsulation layer 50 and then patterned.

The black resin layer 53 can be applied on the encapsulation layer 50 and then patterned. Accordingly, the black resin layer 53 formed on the opening portion 5c can be removed.

The color resin layer 11 can be applied on the black resin layer 53. Accordingly, the color resin layer 11 can be applied not only on the black resin layer 53 but also on the opening portion 5c from which the black resin layer 53 was removed. The color resin layer 11 can be patterned, so that the color resin layer 11 applied on the black resin layer 53 can be removed. Accordingly, the color resin layer 11 can be formed on the opening portion 5c located between the black resin layers 53. The black resin layer 53 can surround the color resin layer 53.

The color resin layer 11 can be formed of red, green, and blue resin or red, blue, green, and transparent resin for each subpixel.

In the above, it is explained that the color resin layer 11 can be applied and patterned after the black resin layer 53 is applied and patterned, but the order can be changed.

The embodiment of the above-described embodiment is an example of the embodiment, and free modification is possible within the scope included in the spirit of the embodiment. Accordingly, the embodiments include modifications of the embodiments within the scope of the appended claims and equivalents thereto.

The embodiment can be adopted in display field that display image or information. The embodiment can be adopted in display field that display image or information using an organic light-emitting element.

For example, the embodiment can be adopted for an HMD-type display. In addition, the embodiment can comprise TV, signage, mobile terminal such as mobile phone and smart phone, display for computer such as laptop and desktop, head-up display (HUD) for automobile, backlight unit for display, display for extend reality (XR) such as AR, VR, mixed reality (MR), etc., light source, etc.

## Claims

1. An organic light-emitting display device, comprising:
a plurality of pixels,
wherein the plurality of pixels each comprise a plurality of subpixels, and
wherein the plurality of subpixels each comprise:
a driving circuit;
a protective layer on the driving circuit;
a color resin layer on the protective layer;
a planarization layer on the color resin layer;
an auxiliary electrode on the planarization layer;
a light guide body having a three-dimensional structure on the auxiliary electrode;
an organic light-emitting element on the light guide body; and
an encapsulation layer on the organic light-emitting element;
wherein the auxiliary electrode is configured to be connected to the driving circuit,
wherein the driving circuit comprises a first opening portion,
wherein the auxiliary electrode comprises a second opening portion and a reflection portion, and
wherein light emitted from the organic light-emitting element is configured to be reflected from the reflection portion and guided by the light guide body to be emitted downward through the first opening portion, the color resin layer, and the second opening portion.

2. The organic light-emitting display device of claim 1, wherein the first opening portion, the color resin layer, and the second opening portion are configured to be vertically overlapped.

3. The organic light-emitting display device of claim 1, wherein an area of the color resin layer is greater than an area of the first opening portion or an area of the second opening portion.

4. The organic light-emitting display device of claim 1, wherein each of the plurality of subpixels comprises an opening portion through which light is transmitted,
and the opening portion comprises the first opening portion and the second opening portion.

5. The organic light-emitting display device of claim 1, wherein a lower surface of the light guide body is disposed in the second opening portion, and
an opposite surface of the lower surface of the light guide body has a round surface or an angled surface that is convex toward an upward direction.

6. The organic light-emitting display device of claim 1, further comprising:
an undercut structure formed along a perimeter of a lower side of the auxiliary electrode;
wherein the organic light-emitting element comprises:
an anode electrode on the light guide body;
an organic light-emitting layer on the anode electrode; and
a cathode electrode on the organic light-emitting layer,
wherein the anode electrode is made of a transparent conductive film,
wherein the cathode electrode is made of a reflective metal film;
wherein the anode electrode is configured to be in contact with a side surface of the auxiliary electrode, and is disposed to be spaced apart from the planarization layer along an inner wall of the undercut structure by the undercut structure.

7. The organic light-emitting display device of claim 6, comprising:
a pixel definition layer between adjacent anode electrodes,
wherein the pixel definition layer is disposed to surround an end of the anode electrode, and
wherein the pixel definition layer comprises at least one trench.

8. The organic light-emitting display device of claim 1, wherein the auxiliary electrode has a triple structure, a double structure, or a single film,
wherein the triple structure comprises a first metal film such as titanium (Ti) or molybdenum (Mo) that is in contact with the driving circuit, a second metal film having reflective properties such as aluminum (Al), silver (Ag), or a silver alloy, and a third metal film that is in contact with the anode electode and has transparency such as ITO or IZO,
wherein the double structure comprises the first metal film and the second metal film, or the second metal film and the third metal film, and
wherein the single film is made of the second metal film.

9. The organic light-emitting display device of claim 1, wherein the light guide body is composed of a transparent resin or an inorganic film on the transparent resin,
wherein a lower surface of the light guide body has a square, rectangular, octagonal, circular or oval shape,
wherein a side surface of the light guide body has a straight side inclined with respect to the lower surface thereof or a round surface,
wherein the light guide body has a structure of a four-pyramid, a four-frustum of pyramid, an ellipsoid cap, a frustum of ellipsoid cap, a circular cone, or a truncated circular cone, and
wherein the lower surface of the light guide body is configured to be in contact with an upper surface of the auxiliary electrode.

10. The organic light-emitting display device of claim 1, wherein the organic light-emitting element has a plurality of organic light-emitting stack structures,
wherein the plurality of organic light-emitting stack structures comprise:
a first organic light-emitting stack in contact with the anode electrode;
a first charge generation layer on the first organic light-emitting stack;
a second organic light-emitting stack on the first charge generation layer;
a second charge generation layer on the second organic light-emitting stack; and
a third organic light-emitting stack on the second charge generation layer, and
wherein the cathode electrode has a single film of a metal such as aluminum (Al), a Mg:Ag alloy or a dual structure combining single films, on an uppermost organic light-emitting stack among the plurality of organic light-emitting stacks.

11. The organic light-emitting display device of claim 1, wherein the encapsulation layer has a triple structure consisting of a first encapsulation film having an inorganic film that has a single film of alumina, silicon nitride film or silicon oxide film or a dual structure combining single films, and a second encapsulation film composed of an organic film on the first encapsulation film, and a third encapsulation film having the same configuration as the first encapsulation film on the second encapsulation film.

12. The organic light-emitting display device of claim 1, wherein the color resin layer is composed of red, green, and blue resins or red, green, blue, and transparent resins for each subpixel.

13. An organic light-emitting display device, comprising:
a plurality of pixels,
wherein each of the plurality of pixels comprises a plurality of subpixels,
whereon each of the plurality of subpixels comprises:
a driving circuit;
auxiliary electrode on the driving circuit;
a light guide body having a three-dimensional structure on the auxiliary electrode;
an organic light-emitting element on the light guide body;
an encapsulating layer on the organic light-emitting element;
a color resin layer on the encapsulating layer; and
a black resin layer on the encapsulating layer,
wherein the auxiliary electrode is connected to the driving circuit;
wherein the organic light-emitting element comprises:
an anode electrode on the light guide body;
an organic light-emitting layer on the anode electrode; and
a cathode electrode on the organic light-emitting layer,
wherein the organic light-emitting element comprises an opening portion and a reflection portion,
wherein the color resin layer is positioned on the opening portion,
wherein light emitted from the organic light-emitting element is configured to be reflected in the reflection portion and guided by the light guide body to be emitted upward through the opening portion and the color resin layer.

14. The organic light-emitting display device of claim 13, wherein the encapsulating layer is in contact with an upper surface of the organic light-emitting layer in the opening portion.

15. The organic light-emitting display device of claim 13, wherein the encapsulation layer is in contact with an upper surface of the light guide body in the opening portion.

16. The organic light-emitting display device of claim 13, wherein a lower surface of the light guide body is in contact with the auxiliary electrode, and
an opposite surface of the lower surface of the light guide body has a round surface or an angled surface that is convex toward an upward direction.

17. The organic light-emitting display device of claim 13, wherein the auxiliary electrode has a triple structure, a double structure, or a single film,
wherein the triple structure comprises a first metal film such as titanium (Ti) or molybdenum (Mo) that is in contact with the driving circuit, a second metal film having reflective properties such as aluminum (Al), silver (Ag), or a silver alloy, and a third metal film that is in contact with the anode electode and has transparency such as ITO or IZO,
wherein the double structure comprises the first metal film and the second metal film, or the second metal film and the third metal film, and
wherein the single film is made of the second metal film.

18. The organic light-emitting display device of claim 13, wherein the light guide body is composed of a transparent resin or an inorganic film on the transparent resin,
wherein a lower surface of the light guide body has a square, rectangular, octagonal, circular or oval shape,
wherein a side surface of the light guide body has a straight side inclined with respect to the lower surface thereof or a round surface,
wherein the light guide body has a structure of a four-pyramid, a four-frustum of pyramid, an ellipsoid cap, a frustum of ellipsoid cap, a circular cone, or a truncated circular cone, and
wherein the lower surface of the light guide body is configured to be in contact with an upper surface of the auxiliary electrode.

19. The organic light-emitting display device of claim 13, wherein the organic light-emitting element has a plurality of organic light-emitting stack structures,
wherein the plurality of organic light-emitting stack structures comprise:
a first organic light-emitting stack in contact with the anode electrode;
a first charge generation layer on the first organic light-emitting stack;
a second organic light-emitting stack on the first charge generation layer;
a second charge generation layer on the second organic light-emitting stack; and
a third organic light-emitting stack on the second charge generation layer, and
wherein the cathode electrode has a single film of a metal such as aluminum (Al), a Mg:Ag alloy or a dual structure combining single films, on an uppermost organic light-emitting stack among the plurality of organic light-emitting stacks.

20. The organic light-emitting display device of claim 13, wherein the encapsulation layer has a triple structure consisting of a first encapsulation film having an inorganic film that has a single film of alumina, silicon nitride film or silicon oxide film or a dual structure combining single films, and a second encapsulation film composed of an organic film on the first encapsulation film, and a third encapsulation film having the same configuration as the first encapsulation film on the second encapsulation film.

21. The organic light-emitting display device of claim 13, wherein the color resin layer is composed of red, green, and blue resins or red, green, blue, and transparent resins for each subpixel, and
wherein the black resin layer is configured to surround the color resin layer.
